# EUROPEAN PATENT SPECIFICATION

(11) **EP 0 654 191 B1**
(45) Date of publication and mention of the grant of the patent: **03.04.2002**
(21) Application number: 92907752.7
(22) Date of filing: 06.02.1992
(51) Int. Cl.: H04B 1/10, H04L 25/49

(54) **APPARATUS AND METHODS EMPLOYING DISTRIBUTION PRESERVING TOMLINSON PRECODING IN TRANSMISSION OF DIGITAL DATA SIGNALS**
VERFAHREN UND GERÄT MIT VERTEILUNGSERHALTENDER TOMLINSON PRÄKODIERUNG BEI ÜBERTRAGUNG VON DIGITALEN DATEN
APPAREIL ET PROCEDES EMPLOYANT UN PRECODAGE TOMLINSON CONSERVANT LA REPARTITION DANS LA TRANSMISSION DE SIGNAUX DE DONNEES NUMERIQUES

(30) Priority: 06.02.1991 US 651563; 13.01.1992 US 820098
(43) Date of publication of application: 24.05.1995
(73) Proprietor: PC TEL, Inc., Waterbury, CT 06705 (US)
(72) Inventor: COLE, Paul, Dana, Fairfield, CT 06430 (US)
(74) Representative: Gibson, Stewart Harry
(86) International application number: PCT/US92/00941
(87) International publication number: WO 92/14306

(56) References cited:
- US-A- 4 535 443
- US-A- 4 837 766
- IEEE INTERNATIONAL CONFERENCE ON COMMUNICATIONS, ICC'89, BOSTON, vol. 2 OF 3, 11 - 14 June 1989, INSTITUTE OF ELECTRICAL AND ELECTRONICS ENGINEERS, pages 1086-1090, XP000075283 KASTURIA S. ET AL.: "PRECODING FOR BLOCK SIGNALING AND SHAPED SIGNAL SETS"

## Description

### BACKGROUND OF THE INVENTION

This invention generally relates to the transmission and receipt of data over telecommunications channels via the use of modems. More particularly, this invention relates to apparatus and methods for modem equilization which predistort data signals in a transmitter prior to sending the signals over a channel.

Data signals which are sent over a channel from a transmitter to a receiver are often corrupted by the inherent characteristics of the channel. Those inherent characteristics include the inability of a channel to provide a perfect response to a signal; i.e. the state of the channel at a previous moment in time affects the response of the channel at a later moment in time. In the art, this is known as intersymbol interference or ISI. In addition to ISI, data signals are also subjected to noise. Both the noise and ISI reduce the ability of a receiver to determine exactly what was transmitted from the transmitter.

In attempting to correct for ISI, it is common in the art to supply an equalizer in the receiver. The function of the equalizer is to correct for the ISI of the received signals so that the initial data can be recovered. With an equalizer in the receiver, typically, a known sequence of data signals (i.e. a training sequence) is sent from the transmitter to the receiver. Being that the data signal sequence itself is known, and the signals being received are known, it is possible for the equalizer first to determine the effects of the channel (i.e. the channel coefficients) on the transmitted signals, and then to compensate for those effects via any of several processes such as linear equalization or decision feedback equalization. Linear equalization functions by multiplying the incoming signals by the inverse of the ISI. While the ISI is generally removed from the incoming signals in this manner, noise inherent in the data transmission is undesirably simultaneously amplified. Additional details of linear equalization may be obtained by reference to Lee, Edward A. and Messerschmitt, David G., Digital Communication; (Kluwer Academic Publishers, 1988).

Decision feedback equalization avoids the noise amplification problems of linear equalization. However, in recreating the ISI via feedback, decision feedback equalization runs the risk of error propagation, as any decision errors that are made are fed back. Additional details of decision feedback equalization may be obtained by reference to Lee, Edward A. and Messerschmitt, David G., Digital Communication; (Kluwer Academic Publishers, 1988).

In response to the problems of linear and decision feedback equalization, M. Tomlinson, "New Automatic Equalizer Employing Modulo Arithmetic"; Electronics Letters Vol. 7, (March, 1971) pp. 138-139, suggested that equalization occur in the transmitter rather than in the receiver. In other words, the signals should be predistorted in the transmitter in such a manner that would cancel out the ISI of the channel upon transmission. As a result, after travel through the channel, the signals being received by the receiver would correspond to those signals which were generated by the transmitter prior to the predistortion, except for noise. The noise accompanying the data would not be amplified.

In more mathematical terms, if a series of data points rₖ are to be sent from the transmitter to the receiver, the Tomlinson scheme precodes the data according to a linear function:${\text{x}}_{\text{k}} {\text{+ Σ}}_{\text{1≥1}} {\text{h}}_{\text{1}} {\text{x}}_{\text{k-1}} {\text{= r}}_{\text{k}} \text{mod M}$ where xₖ is the ISI corrected (i.e. predistorted) signal which is transmitted over the channel, rₖ is the precorrected selected signal point, and h₁ are the coefficients of a polynomial which describes the channel's impulse response (i.e. ISI).

While Tomlinson precoding is generally effective, the manner in which Tomlinson processes the signals prior to transmission causes signals having a desired power distribution which provides coding gain to lose that gain. In other words, if the Tomlinson precoding is to be used, there is no benefit in providing a signal constellation having a desired "shape" or power distribution, as the Tomlinson precoding substantially destroys desired power distributions of coded signals. While for certain data transmission schemes this feature is acceptable, in high speed modems (e.g. 19.2 kbits/sec), it is advantageous that any gain available be maintained.

Recently, in Forney Jr., G. David, "Trellis Shaping", IEEE Information Theory Workshop, CCITT Study Group XVII & Working Parties, Geneva 15-23 October 1990 (Temporary Document 211-E), and in Forney Jr., G. David, "Trellis Precoding: Combined Coding, Precoding and Shaping for Intersymbol Interference Channels", IEEE Information Theory Workshop, CCITT Study Group XVII & Working Parties, Geneva 15-23 October 1990 (Temporary Document 212-E), Forney proposed an equalization scheme which avoids the drawbacks of both the equalization in the receiver, and the Tomlinson precoding methods. As set forth in the Forney articles, Trellis encoded and modulated data signals are predistorted to account for ISI in a manner which simultaneously provides minimum possible energy of the transmitted signal. While the Forney method theoretically provides excellent results, it has several drawbacks. First, the shaping scheme of Forney adds considerable delay to the process of transmitting data. Second, the Forney method requires very complex processing.

IEEE International Conference on Communication, ICC '89, Boston, vol. 2 of 3, 11-14 June 1989 Institute of Electrical & Electronics Engineers, pages 1086-1090, Kasturia S. et al: 'Precoding for Block Signalling and Shaped Signal Sets' describes a modified precoder with permits the use of signal constellations with non-rectangular shapes which keep their shaping gain at the output of the precoder. The mapping proposed is denoted by F, and the property of F that is specified as essential to the performance of the precoder is:$\text{F(F(A)B-AB) = 0}$ where A is a point in a four dimensional space and B is a 4 by 4 matrix.

### SUMMARY OF THE INVENTION

It is therefore an object of the invention to provide a transmitter which predistorts data signals having a desired power distribution without destroying the power distribution of the data signals.

It is another object of the invention to provide a transmitter which straight-forwardly predistorts coded data signals while substantially maintaining the power distribution of those coded data signals.

It is a further object of the invention to provide a transmitter which predistorts coded data signals without introducing additional delay and which substantially maintains the power distribution of the coded data signals.

It is an additional object of the invention to provide a receiver having a decoder for decoding coded data signals which have been predistorted without destroying the power distribution of the coded data signals and which have been sent through a distorting channel.

It is yet a further object of the invention to provide a digital telecommunications system having a transmitter and receiver where predistorted shaped data signals are transmitted over a channel, and shaped data signals received by the receiver are decoded.

In accord with the objects of the invention, there is provided a transmitter for transmitting a series of data signals over a channel, said transmitter comprising:
coding means for precoding data signals according to a linear function, characterised in that the coding means is for predistorting data signals according to the linear function: linear function is: 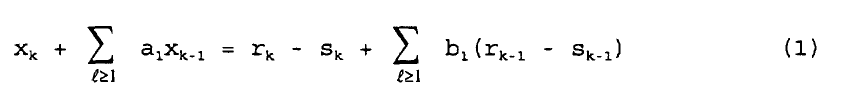 so as to provide predistorted output data signals, wherein rₖ represents a data signal which is to be predistorted by said coding means, a₁ and b₁ respectively represent coefficients of first and second polynomials relating to the channel impulse response of said channel, xₖ represents a predistorted output data signal, and sₖ is chosen to cause the signal power of xₖ on average to approximately equal the signal power of rₖ on average.

Different manners of choosing sₖ to cause the signal power of xₖ on average to approximately equal the signal power of rₖ on average are envisaged. For example, sₖ may be chosen as a multiple of a given value N which is chosen to cause xₖ and rₖ to occupy identical defined regions in space, where the total length and/or width of each defined region is the given value N; or sₖ may be chosen to cause xₖ to approximate rₖ (i.e., sₖ chosen closest to Σ_{1≥1} b₁(rₖ₋₁ - sₖ₋₁) - Σ_{1≥1} a₁xₖ₋₁). In one embodiment of the invention, sₖ may be chosen at the transmitter according to a second linear function:${\text{X}}_{\text{k}} {\text{+ Σ}}_{\text{1≥1}} {\text{u}}_{\text{1}} {\text{X}}_{\text{k-1}} {\text{= r}}_{\text{k}} {\text{- s}}_{\text{k}} {\text{+ Σ}}_{\text{1≥1}} {\text{v}}_{\text{1}} {\text{(r}}_{\text{k-1}} {\text{- s}}_{\text{k-1}} \text{)}$ where rₖ is a data signal entering the precoding means, Xₖ an approximator of xₖ, u₁ and v₁ are the coefficients of polynomials chosen such that Xₖ is an approximator of xₖ, and sₖ is chosen to cause the signal power of Xₖ on average to approximately equal the signal power of rₖ on average. Typically, the coefficients u_{ℓ} are set to zero. Where sₖ is chosen according to equation (2), it will be appreciated that upon sending a signal, predistortion itself is still accomplished according to equation (1). It should also be appreciated in using the approximation linear function (2) in choosing sₖ, that sₖ may still be chosen as a multiple of a given value N chosen to cause Xₖ and rₖ to occupy identical defined regions in space, or to cause Xₖ to approximate rₖ (i.e., sₖ chosen closest to Σ_{1≥1} v₁(rₖ₋₁ - sₖ₋₁). Thus, four different combinations are set forth: choose sₖ as a multiple of a given value to cause xₖ and rₖ to occupy identical defined regions in space, where sₖ is chosen according to equation (1) and predistortion is accomplished according to equation (1); choose sₖ as a multiple of a given value to cause approximator Xₖ and rₖ to occupy identical defined regions in space, where sₖ is chosen according to equation (2) and predistortion is accomplished according to equation (1); choose sₖ to cause xₖ to approximate rₖ and predistortion is accomplished according to equation (1); and choose sₖ to cause approximator X_{K} to approximate rₖ (as in equation (2)) and accomplish predistortion according to equation (1).

Where the first of the four combinations is used, and a one-dimensional system is utilized, rₖ, xₖ, and sₖ are preferably real numbers, and the regions of length N in space occupied by xₖ and rₖ are along a line, while where a two-dimensional system is utilized, rₖ, xₖ, and sₖ are preferably complex numbers, and xₖ and rₖ are located within areas located within two-dimensional regions which are Cartesian products of two one-dimensional regions.

According to preferred aspects of the invention, the regions may be chosen in different ways. In a first embodiment, regions are chosen as non-overlapping adjacent segments of equal length N. In a second embodiment, regions are chosen as non-overlapping adjacent segments of equal length N, except that zero is not in any region; i.e. rₖ and xₖ cannot equal zero. In a third embodiment, regions are chosen as the union of segments, wherein points having opposite values are in the same region, except that end points are treated differently. In two dimensions for all three cases, the imaginary portion of the signal is treated separately, but identically to the real portion of the signal.

For purposes of simplification, sₖ is preferably an even integer (i.e. N=2), rₖ is preferably a non-integer, and scaling prior to and after predistortion is utilized where necessary.

Further in accord with the objects of the invention, there is provided a receiver for receiving a series of signals over a channel from a transmitter, said receiver comprising means for receiving said series of signals, and decoder means; characterized in that said series of signals were first predistorted according to a linear function 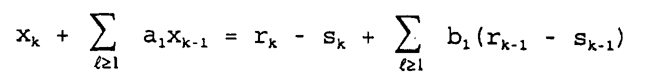 and then subjected to ISI of said channel and noise, wherein rₖ represents a signal which is to be predistorted according to said linear function, a₁ and b₁ represent coefficients of polynomials relating to said channel ISI, xₖ represents a signal which is subjected to said ISI, and sₖ is chosen to cause the signal power of xₖ on average to approximately equal the signal power of rₖ on average; and in that
a) said means for receiving said series of signals is for generating from a k'th signal of said series of signals an estimate of rₖ - sₖ; and
b) said decoder means is for generating from said estimate of rₖ - sₖ an estimate of xₖ, and for generating from said estimates of xₖ and rₖ - sₖ an estimate of sₖ, and for determining from said estimate of rₖ - sₖ and said estimate of sₖ an estimate of rₖ.

On the other hand, if the transmitter, sₖ was chosen to cause xₖ or Xₖ to approximate rₖ, then sₖ is taken as the closest point to an estimate of Σ_{1≥1} b₁(rₖ₋₁ - sₖ₋₁) - Σ_{1≥1} a₁xₖ₋₁) or to an estimate of Σ_{1≥1} v₁(rₖ₋₁ - sₖ₋₁) - Σ_{1≥1} u₁Xₖ₋₁).

A telecommunication system of the invention preferably utilizes the above-summarized transmitter and the above-summarized receiver. The methods of the invention relate closely to transmitter, receiver and system apparatus inventions.

Additional objects and advantages of the invention will become apparent to those skilled in the art upon reference to the detailed description taken in conjunction with the drawings.

### BRIEF DESCRIPTION OF THE DRAWINGS

Figure 1 is a block diagram of a portion of the transmitter of the invention.

Figure 2 is a flow chart of the method of the invention carried out in the distribution preserving Tomlinson encoder of Fig. 1.

Figure 3 is a block diagram of a portion of the preferred receiver of the invention.

Figure 4 is a flow chart of the method of the invention carried out in the distribution preserving Tomlinson decoder of Fig. 3.

### DETAILED DESCRIPTION OF THE PREFERRED EMBODIMENTS

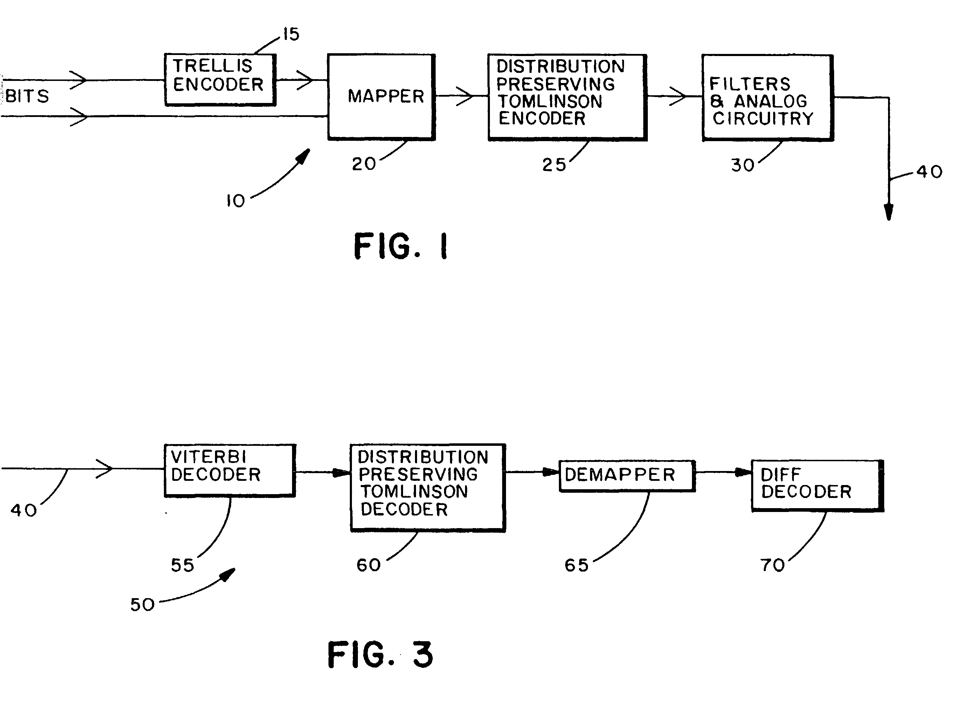

A portion of a modem transmitter 10 is seen in Fig. 1. The preferred transmitter 10, as shown, includes a Trellis encoder 15, a mapper 20, a distribution preserving Tomlinson encoder 25, and filters and analog circuitry 30 for interfacing with a channel 40. Details of a Trellis encoder 15 may be found in Lee, Edward A. and Messerschmitt, David G., Digital Communication; (Kluwer Academic Publishers, 1988). The mapper 20 preferably provides to the distribution preserving Tomlinson encoder 25 a series of data signals which are drawn from a "shaped" constellation; i.e. a series of data signals having a desired power distribution. The function of the distribution preserving Tomlinson encoder 25 is to predistort the data signals to account for channel ISI while simultaneously substantially maintaining the power distribution of the data signals being transmitted.

According to the invention, predistortion is accomplished in the distribution preserving Tomlinson encoder 25 according to a linear function (set forth above as equation 1)${\text{x}}_{\text{k}} {\text{+ Σ}}_{\text{1≥1}} {\text{a}}_{\text{1}} {\text{x}}_{\text{k-1}} {\text{= rk - s}}_{\text{k}} {\text{+ Σ}}_{\text{1≥1}} {\text{b}}_{\text{1}} {\text{(r}}_{\text{k-1}} {\text{- s}}_{\text{k-1}} \text{)}$ where rₖ is the data signal generated by mapper 20 and forwarded to the encoder 25, a₁ and b₁ are the coefficients of polynomials relating to the channel impulse response, xₖ is the predistorted data signal exiting the distribution preserving Tomlinson encoder 25, and sₖ is chosen to cause the signal power of xₖ on average to approximately equal the signal power of rₖ on average.

In accord with the invention, there are four different preferred manners of choosing sₖ. A first manner is to choose sₖ as a multiple of a given value (N) which is chosen to cause xₖ and rₖ to occupy identical defined regions in space, where the total length and/or width of each defined region is the given value N. Where this first manner of choosing sₖ is used, and where a one-dimensional system is utilized, rₖ, xₖ, and sₖ are preferably real numbers, and the regions of total length N in space occupied by xₖ and rₖ are along a line, while where a two-dimensional system is utilized, rₖ, xₖ, and sₖ are preferably complex numbers, and xₖ and rₖ are located within areas located within two-dimensional regions which are Cartesian products of the two one-dimensional regions.

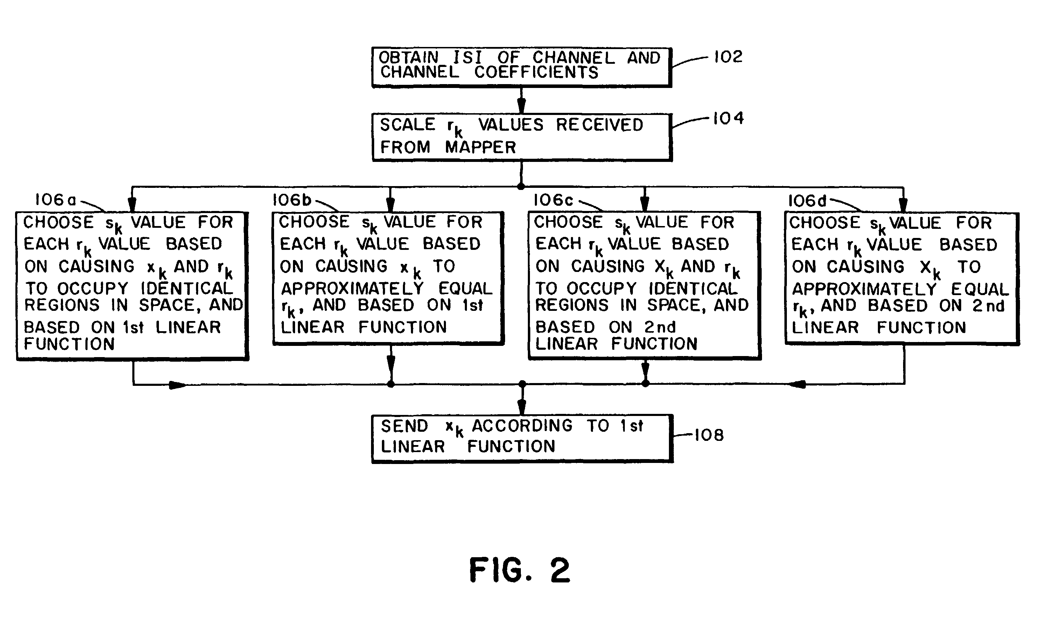

More particularly, and as shown in Fig. 2, at step 102 the distribution preserving Tomlinson encoder 25 obtains the ISI of the channel 40 (e.g. from memory); the ISI having typically been determined initially by a receiver via the use of training sequence technology, and communicated back to the transmitter. As part of step 102, the channel coefficients a₁ and b₁ are obtained (e.g. from memory) such that (1 + Σ_{1≥1} a₁D¹)/(1 + Σ_{1≥1} b₁D¹) approximates the channel impulse response polynomial (1 + Σ_{1≥1} h₁D¹). Then, at step 104, the rₖ value from the mapper 20 (which is preferably obtained via the mapping technique described in U.S. Serial Nos. 07/535,329 and 07/640,260 which were previously incorporated by reference herein) is preferably scaled such that the input of mapper 20 is a half-integer; e.g. ... -1/2, 1/2, 3/2, 5/2, etc. At step 106a, a value for sₖ is chosen, based on the output rₖ of the mapper 20, and based on the linear function (1). The sₖ values are preferably even integers (i.e. they are multiples of 2), and are chosen to cause xₖ and rₖ to occupy identical defined regions in space, as set forth hereinafter in more detail.

According to preferred aspects of the invention, the defined regions in space which xₖ and rₖ occupy are preferably one dimensional regions (i.e. portions of a line), or two dimensional regions (i.e. areas of a plane), and may be chosen in different ways. According to a first embodiment, where regions are one dimensional, the regions are chosen as non-overlapping adjacent segments of equal length. According to a second embodiment of one dimensional regions, the regions are chosen as non-overlapping adjacent segments of equal length except that zero is not in any region; i.e. rₖ and xₖ cannot equal zero. According to a third embodiment of one dimensional regions, the regions are chosen as the union of segments, wherein points having opposite values are in the same region, except that end points are treated differently. In two dimensions for all three cases, the imaginary portion of the signal is treated separately, but identically to the real portion of the signal.

Describing in more mathematical terms the one-dimensional methods set forth above for picking the sₖ values, it can be said that ideally, and in accord with a first embodiment, a real line R can be partitioned into equal sized non-overlapping regions Gₙ where n ranges over some index set. Based on this partitioning of R, the following holds: if n₁ = n₂, then Gₙ₁ and Gₙ₂ have no points in common; and R is the union of all regions Gₙ
where n ranges over the index set. As a result, every real number α is located in exactly one region Gₙ, and the index n(α) of α can be defined such that α lies in G_{n(α)}. Further defining Gₙ, each region Gₙ may be chosen to be a fundamental region for the even integers in the real line R. In other words, for any real number β, there is exactly one even integer s such that β - s lies in Gₙ.

Rewriting equation (1) set forth above for data signals being transmitted over a channel, each xₖ may be defined by${\text{x}}_{\text{k}} {\text{= r}}_{\text{k}} {\text{- s}}_{\text{k}} {\text{+ σ}}_{\text{k}}$ where sₖ is the even integer for which n(xₖ) = n(rk). In order to accommodate coding/decoding, the only restriction on the coding of the input sequence {rₖ} is that the hereinafter described receiver must recognize {rₖ + zₖ} as a valid coded sequence whenever {rₖ} is a coded sequence and {zₖ} is a sequence of even integers. Further, in order to accommodate differential encoding/decoding, if {xₖ} is the output sequence generated by the input sequence {rₖ}, then {-xₖ} should be the output sequence generated by the input sequence {-rₖ}. To achieve this, either of the second or third embodiments which modify the ideal partitioning of line R (i.e. the first embodiment) may be utilized. According to the second embodiment, the index set is the set of odd integers, and Gₙ = (n-1, n+1] if n > 0, and Gₙ = [n-1, n+1) if n < 0. Thus, if n=1, Gₙ is a region or segment from just above zero to two; if n=3, Gₙ is a region or segment from just above two to four; if n=-1, Gₙ is a region from minus two to just below zero. The only restriction on rₖ is that rₖ never equals zero. With such an arrangement, each Gₙ is a fundamental region for the even integers in the real line R. The union of regions Gₙ is the non-zero real numbers, and each region Gₙ is of identical size.

The third embodiment for modifying the ideal partitioning of line R is to identify an index set of non-negative integers, and set Gₙ = (-n-1, -n) U (n, n+1). In this case, where n equals zero, Gₙ is the union of just above minus one to just below zero and just above zero to just below one; i.e. the region or segment from minus one to one, with the integers not included. If n equals one, Gₙ is the union of the segment from just above minus two to just below minus one, and the segment from just above one to just below two. With this arrangement, the only restriction on rₖ is that it never be an integer. With the rₖ inputs coming from the mapper, this restriction is easily met via scaling.

Using the third embodiment, where Gₙ = (-n-1, -n) U (n, n+1), and equation (2) set forth above, sₖ is chosen to be an even integer selected in the following manner. If rₖ + σₖ is not an integer, sₖ is selected so that n(xₖ) = n(rₖ). If, on the other hand, rₖ + σₖ is an integer, sₖ is selected so that xₖrₖ ≥ 0 and so that xₖ = -n(rₖ) -1, - n(rk), n(rₖ), or n(rₖ)+1. In other words, when rₖ + σₖ is not an integer, the even integer sₖ is chosen to bring rₖ into the same region as xₖ. When r ₖ+ σₖ is an integer, then subtraction of an even integer sₖ will yield an integer, and sₖ is chosen in a well-defined manner such that if rₖ is negative, xₖ is either zero or negative (depending upon σₖ and the index n), and if rₖ is positive, xₖ is either zero or positive (again depending upon σₖ and the index n).

While the mathematics set forth above deals in only one dimension, the extension to two or more dimensions is straight-forward. For example, in two dimensions, the sequence {rₖ} is a sequence of complex numbers having real and imaginary portions: Re(rₖ) and Im(rₖ). The real and imaginary portions of the sequence {rₖ} are treated separately, but each is treated exactly as set forth above. Thus, for example, where the embodiment of Gₙ = (-n-1, -n) U (n, n+1) is utilized, and the real portion of rₖ + σₖ is not an integer, Re(s ) is selected so that n(Re(xₖ)) = n(Re(rₖ)); and if, on the other hand, the real portion of rₖ + σₖ is an integer, Re(sₖ) is selected so that Re(xₖ)Re(rₖ) ≥ 0 and so that Re(xₖ) =-n(Re(rₖ))-1, -n(Re(rₖ)), n(Re(rₖ)), or n(Re(rₖ)) +1. Likewise, where the imaginary portion of rₖ + σₖ is not an integer, Im(sₖ) is selected so that n(Im(xₖ)) = n(Im(rₖ)); and if, on the other hand, the imaginary portion of rₖ + σₖ is an integer, Im(sₖ) is selected so that Im(xₖ)Im(rₖ) ≥ 0 and so that Im(xₖ) = -n(Im(rₖ))-1, -n(Im(rₖ)), n(Im(rₖ)), or n(Im(rₖ))+1.

A second manner of choosing sₖ is substantially similar to the first manner set forth above except that instead of choosing sₖ to cause xₖ and rₖ to occupy identical defined regions in space, sₖ is chosen to cause xₖ to approximate rₖ. In other words, using equation (1), sₖ is chosen as the sₖ value closest to Σ_{1≥1} b₁(rₖ₋₁ - sₖ₋₁) - Σ_{1≥1} a₁xₖ₋₁). In order to break a tie, any tie-breaking scheme can be utilized, such as, e.g., using the sₖ which is closest to zero.

It will be appreciated that in choosing a set S of sₖ's which can be used to cause xₖ to approximate rₖ, any number of sₖ's can be utilized, provided at least zero and at least one other value are included. In particular, the set of rₖ - sₖ's is an enlargement of the set of rₖ's. The size of the enlargement of the set of rₖ - sₖ's is dependent on the size of the set S. While a large number of sₖ's is beneficial for accuracy, it will be appreciated that a reduction in the number of rₖ - sₖ's chosen can enhance the estimation procedures used in the receiver as well as providing simplicity in the receiver and transmitter.

A third manner of choosing sₖ is also substantially similar to the first manner set forth above, except that instead of using sₖ to cause xₖ and rₖ to occupy identical defined regions in space, sₖ is instead chosen to cause Xₖ and rₖ to occupy identical defined regions in space, where Xₖ is an approximation of xₖ and is defined by a linear function as set forth in equation (2) above:${\text{X}}_{\text{k}} {\text{+ Σ}}_{\text{1≥1}} {\text{u}}_{\text{1}} {\text{X}}_{\text{k-1}} {\text{= r}}_{\text{k}} {\text{- s}}_{\text{k}} {\text{+ Σ}}_{\text{1≥1}} {\text{v}}_{\text{1}} {\text{(r}}_{\text{k-1}} {\text{- s}}_{\text{k-1}} \text{)}$ where rₖ is a data signal entering the precoding means, and u₁ and v₁ are the coefficients of polynomials chosen such that Xₖ is an approximator of xₖ. Once sₖ is so chosen, predistortion is accomplished according to equation (1) set forth above. Effectively, then, in the third (and preferred) embodiment sₖ is chosen based on an approximation. The use of an approximation is advantageous because it includes, among others, the case where the u₁ coefficients are zero. When the u₁ coefficients are zero, feedback is eliminated in the decoding algorithm of the receiver.

In the third manner of choosing sₖ, it will be appreciated that sₖ is a multiple of a given value (N) where the length and/or width of each defined region is the given value N. Where a one-dimensional system is utilized, rₖ, Xₖ, and sₖ are preferably real numbers, and the regions of total length N in space occupied by Xₖ and rₖ are along a line, while where a two-dimensional system is utilized, rₖ, Xₖ, and sₖ are preferably complex numbers, and Xₖ and rₖ are located within areas located within two-dimensional regions which are Cartesian products of the two one-dimensional regions.

The fourth manner of choosing sₖ is effectively a combination of aspects of the second and third manners; i.e., sₖ is chosen to cause the approximation Xₖ to approximate rₖ. In other words, in choosing sₖ, the approximation of equation (2) is utilized, and instead of using sₖ to cause Xₖ and rₖ to occupy identical defined regions in space, sₖ is chosen to cause Xₖ to be substantially equal to rₖ; i.e., the sₖ is chosen as the sₖ value closest to Σ_{1≥1} v₁(rₖ₋₁ - sₖ₋₁) - Σ_{1≥1} u₁Xₖ₋₁). Again, the sₖ's in the set S should include at least the value zero and one other value, and can be limited based on the discussion above.

More particularly, and as aforementioned with respect to Fig. 2, at step 102 the distribution preserving Tomlinson encoder 25 obtains the ISI of the channel 40 (e.g. from memory); the ISI having typically been determined initially by a receiver via the use of training sequence technology, and communicated back to the transmitter. As part of step 102, the channel coefficients a₁ and b₁ are obtained (e.g. from memory) such that
(1 + Σ_{1≥1} a₁D¹)/(1 + Σ_{1≥1} b₁D¹) approximates the channel impulse response. Then, at step 104, the rₖ value from the mapper 20 is preferably scaled such that the input of mapper 20 is a half-integer; e.g. ... -1/2, 1/2, 3/2, 5/2, etc., (although such scaling is not necessarily required). Then, a value for sₖ must be chosen to cause the signal power of xₖ on average to approximately equal the signal power of rₖ on average. The manner in which sₖ is chosen is according to any of the four previously described manners. Thus, as seen at 106a, sₖ is chosen for each rₖ value based on causing xₖ and rₖ to occupy identical regions in space, and based on the first linear function. As seen at 106b, sₖ is chosen for each rₖ value based on causing xₖ to approximately equal rₖ, and based on the first linear function. As seen at 106c, sₖ is chosen for each rₖ value based on causing Xₖ and rₖ to occupy identical regions in space, and based on the second linear function. As seen at 106d, sₖ is chosen for each rₖ value based on causing Xₖ to approximately equal rₖ, and based on the second linear function. Regardless of how sₖ is chosen, at 108, xₖ is sent according to the first linear function.

Where sₖ is chosen to cause xₖ or Xₖ and rₖ to occupy identical defined regions in space, the regions may be defined in manners set forth above or in other suitable manners. Also, for these situations, as described above, the sₖ values are preferably even integers (i.e. they are multiples of 2). On the other hand, regardless of whether sₖ is chosen to cause xₖ or Xₖ and rₖ to occupy identical defined regions in space or is chosen to cause xₖ or Xₖ to be approximately equal to rₖ, in order to accommodate coding/decoding, the only restriction on the coding of the input sequence {rₖ} is that the hereinafter described receiver must recognize {rₖ - sₖ} as a valid coded sequence whenever {rₖ} is a coded sequence of rₖ's, and {rₖ - sₖ} is a corresponding sequence of rₖ - sₖ's. Further, in order to accommodate differential encoding/decoding, if {xₖ} is the output sequence generated by the input sequence {rₖ}, then {-xₖ} should be the output sequence generated by the input sequence {-rₖ}.

While the mathematics set forth above deals in only one dimension, the extension to two dimensions is straight-forward. In two dimensions, the sequence {rₖ} is a sequence of complex numbers having real and imaginary portions: Re(rₖ) and Im(rₖ). In fact, extension to more than two dimensions will suggest itself to those skilled in the art.

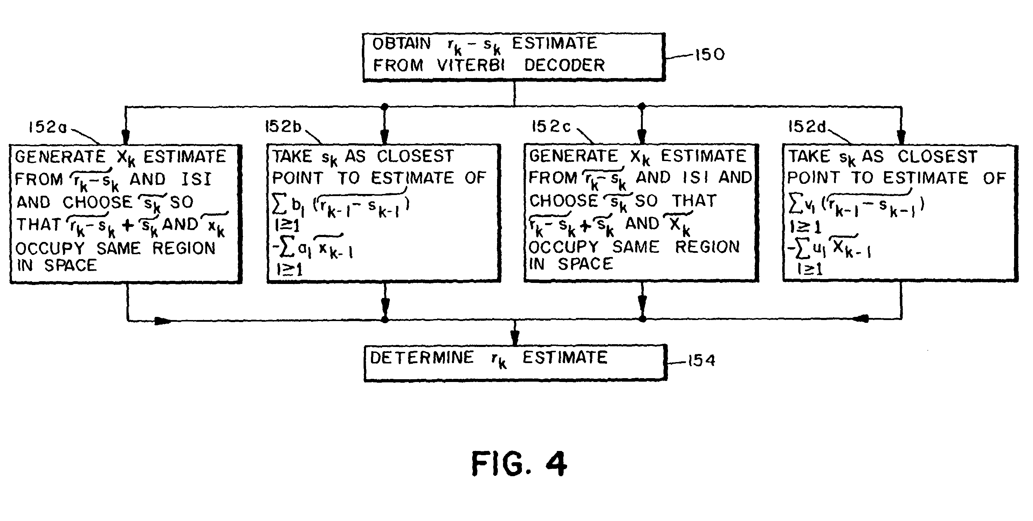

Turning to Fig. 3, a block diagram of the receiver 50 of the invention is seen. The preferred receiver includes a Viterbi decoder 55, a distribution preserving Tomlinson decoder 60, a demapper 65, and in some embodiments a differential decoder 70. The function of the Viterbi decoder 55 is to receive the signals sent over channel 40, and to decode the Trellis coding so as to provide an estimate of rₖ - sₖ; i.e. 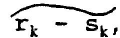 to the distribution preserving Tomlinson decoder. From 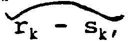 the distribution preserving Tomlinson decoder 60 of the invention finds values for the series of rₖ, which are estimates of rₖ, as set forth in more detail with reference to Fig. 4. The 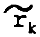 values are then sent to the demapper 65 which provides to the differential decoder 70 a series of points drawn from a constellation.

Details of the manner in which the distribution preserving Tomlinson decoder 60 determines 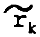 are seen with reference to Fig. 4. At step 150, the decoder 60 receives 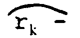 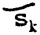 from the Viterbi decoder 55. Then, if in the transmitter, sₖ was chosen to cause xₖ and rₖ to occupy identical regions in space, then at 152a from the estimate of rₖ - sₖ, the decoder of the receiver preferably generates an estimate of xₖ ( 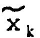 ) by multiplying the received estimate by the ISI; i.e., 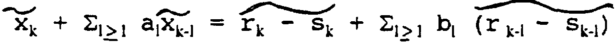 Then sₖ is chosen so that 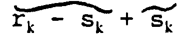 and 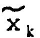 occupy the same region in space. If, in the transmitter, sₖ was chosen to cause xₖ to approximately equal rₖ, then at 152b, 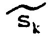 is taken as the closest point to 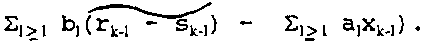 Where the u₁ coefficients are taken as zero, no xₖ₋₁ values need be generated. However, where one or more of the u₁ coefficients are not zero, the 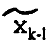 values are the previous estimates xₖ generated as above. If, in the transmitter sₖ was chosen to cause Xₖ and rₖ to occupy identical regions in space, then from the estimate of rₖ - sₖ, then at 152c the decoder of the receiver preferably generates an estimate of Xₖ by multiplying the received estimate by the ISI; i.e., 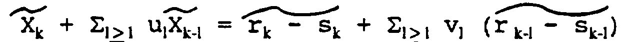 Then sₖ is chosen so that 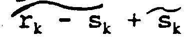 and 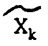 occupy the same region in space. Finally, if, in the transmitter, the sₖ was chosen to cause Xₖ to approximately equal rₖ, than at 152d, 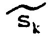 is taken as the closest point to 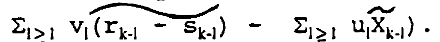 Again, if the u₁ coefficients are not zero, the 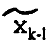 values are previous estimates 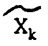 as generated above. Regardless of the manner in which sₖ is derived, at step 154, from the estimate of sₖ, the decoder 60 determines rₖ according to 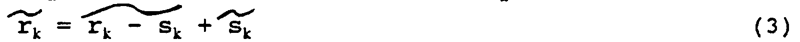 For example, and with reference to the embodiment where in the transmitter, sₖ was chosen to cause xₖ and rₖ to occupy identical regions in space, at step 154, from the estimate 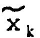 (which provides an indication of the value n) and from the estimate 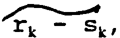 the decoder 60 determines rₖ according to 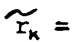 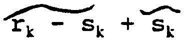 where 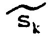 is an even integer estimate of sₖ. Values of 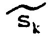 are determined according to the embodiment used in coding. For example, if the regions Gₙ were chosen as non-overlapping adjacent segments of equal length or as non-overlapping adjacent segments of equal length except that zero is not in any region, the estimate 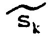 is selected so that n( 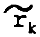 ) = n( 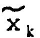 ). On the other hand, if the regions Gₙ were chosen such that Gₙ = (-n-1, -n) U (n, n+1), then in the decoder, if the estimate 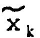 is not an integer, the estimate 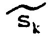 is selected so that n( 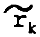 ) = n( 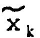 ); while if the estimate 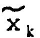 is an integer, the estimate 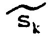 is selected so that the estimate 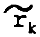 lies in the union of segments defined by

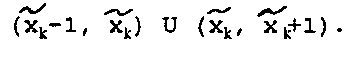

While the above disclosure regarding the receiver of the invention deals in only one dimension, the extension to two dimensions is straight-forward. For example, in two dimensions, the sequence {rₖ - sₖ} is a sequence of complex numbers having real and imaginary portions: Re(rₖ - sₖ) and Im(rk - sₖ). As with the transmitter, in the receiver, the real and imaginary portions are treated separately, but each is treated exactly as set forth above. Again, extension to more than two dimensions will suggest itself to those skilled in the art.

The telecommunication system invention preferably utilizes the transmitter and the receiver invention previously described. It will be appreciated that where a particular embodiment of the transmitter is utilized, a corresponding embodiment of the receiver should be utilized for compatibility.

There have been described and illustrated herein transmitters provided with (pre)coding means which predistorts shaped data signals such that the power of each data signal exiting the precoding means is substantially similar to the power of the data signal entering the precoding means and such that upon transmission of the predistorted data signal over a channel, the effect of intersymbol interference of the channel is substantially removed. Also described and illustrated herein are receivers which cooperate with such transmitters. While particular embodiments have been described, it will be appreciated that it is not intended that the invention be limited thereby, as it is intended that the invention be as broad in scope as the art will allow. Thus, while the transmitters of the invention were described as preferably having Trellis encoders, and the receivers of the invention were described as preferably having Viterbi decoders, it will be appreciated that the invention has application to transmitters and receivers employing different types of coding, or no coding at all. Also, while the invention suggested use of certain mappers providing coding gain, it will be appreciated that other mappers could be utilized. In fact, it will be appreciated by those skilled in the art that the mapping function can be integrated into the distribution preserving Tomlinson encoder such that the rₖ values are coset representatives (one for each coset), and the indices nₖ = n(xₖ) are supplied by some means external to the invention. Of course, it will be appreciated that the precoding and decoding are carried out using standard apparatus such as properly programmed DSPs, microprocessors or other processors.

Those skilled in the art will also appreciate that while the invention was set forth in detail for one dimensional signals, and for two dimensional signals based on a rectangular grid, the concepts of the invention also apply to two dimensional signals based on other grids (e.g. hexagonal) as well as to signals having three or more dimensions. In fact, even though the disclosed implementation of the invention has deficiencies when one or more of the coefficients a₁ or u₁ is not zero, those skilled in the art will appreciate that various techniques can be utilized to overcome those deficiencies. Therefore, it will be apparent to those skilled in the art that yet other changes and modifications may be made to the invention as described without departing from the scope of the invention as claimed.

## Claims

1. A transmitter (10) for transmitting a series of data signals over a channel (40), said transmitter (10) comprising:
coding means (25) for precoding data signals according to a linear function, **characterised in that** the coding means is adapted for predistorting data signals according to the linear function: 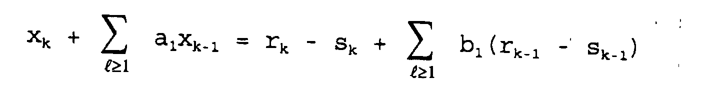 so as to provide predistorted output data signals, wherein rₖ represents a data signal which is to be predistorted by said coding means, a₁ and b₁ respectively represent coefficients of first and second polynominals relating to the channel impulse response of said channel, xₖ represents a predistorted output data signal, and sₖ is chosen to cause the signal power of xₖ on average to approximately equal the signal power of rₖ on average.

2. A transmitter (10) according to claim 1, wherein:
sₖ is chosen to cause xₖ to be approximately equal to rₖ.

3. A transmitter (10) according to claim 1, wherein:
sₖ is chosen according to a second linear function 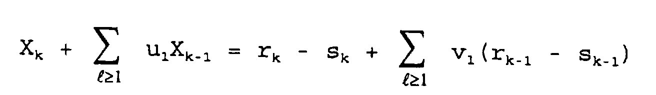 where Xₖ an approximator of xₖ, and u₁ and v₁ respectively represent coefficients of first and second polynominals chosen to cause Xₖ to approximate xₖ, and
sₖ is multiple of a given value N which is chosen by said coding means to cause Xₖ and rₖ to occupy identical defined regions in space, where the total length and/or width of each defined region is the given value N.

4. A transmitter (10) according to claim 1, wherein:
sₖ is chosen according to a second linear function 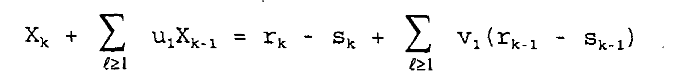 where Xₖ is an approximator of xₖ, and u₁ and v₁ respectively represent coefficients of first and second polynomials chosen to cause Xₖ to approximate xₖ, and
sₖ is chosen to cause Xₖ to be approximately equal to rₖ.

5. A transmitter (10) according to claim 3, wherein:
rₖ, Xₖ, and sₖ are complex numbers having real and imaginary portions, and Xₖ and rₖ are located within identical two-dimensional regions which are Cartesian products of a defined real and defined imaginary one-dimensional region, each of total length N.

6. A transmitter (10) according to claim 1, wherein:
the real portion of sₖ and the imaginary portion of sₖ are even integers, and the real portion of rₖ and the imaginary portion of rₖ are scaled data signals.

7. A transmitter (10) according to claim 1, wherein:
sₖ is a multiple of a given value N which is chosen to cause xₖ and rₖ to occupy identical defined regions in space, where the total length and/or width of each defined region is the given value N.

8. A transmitter (10) according to claim 7, wherein:
rₖ, xₖ, and sₖ are real numbers, and the regions of length N in space occupied by xₖ and rₖ are along a line, or
rₖ, xₖ and sₖ are complex numbers having real and imaginary portions, and xₖ and rₖ are located within identical two-dimensional regions which are Cartesian products of a defined real and a defined imaginary one-dimensional region, each of total length N.

9. A transmitter (10) according to claim 8, wherein:
if the regions of length N in space occupied by xₖ and rₖ are along a line, said defined regions each comprise a union of segments, wherein points having opposite values are in the same region Gₙ, n is a region index, and rₖ is a non-integer real number, and
if xₖ and rₖ are located within identical two-dimensional regions, each said defined real one-dimensional region comprises a union of segments, wherein points having opposite values are in the same region Gₙᵣ, each said defined imaginary one-dimensional region comprises a union of segments, wherein points having opposite values are in the same region Gₙᵢ, wherein nᵣ and nᵢ are region indices, and neither Re(rₖ) nor Im(rₖ) is an integer.

10. A receiver (50) for receiving a series of signals over a channel (40) from a transmitter (10), said receiver (50) comprising means (55) for receiving said series of signals, and decoder means (60); **characterized in that** said series of signals were first predistorted according to a linear function 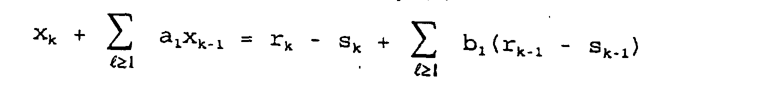 and then subjected to ISI of said channel (40) and noise, wherein rₖ represents a signal which is to be predistorted according to said linear function, a₁ and b₁ represent coefficients of polynomials relating to said channel ISI, xₖ represents a signal which is subjected to said ISI, and sₖ is chosen to cause the signal power of xₖ on average to approximately equal the signal power of rₖ on average; and **in that**
a) said means (55) for receiving said series of signals is adapted for generating from a k'th signal of said series of signals an estimate of rₖ - sₖ; and
b) said decoder means (60) is for generating from said estimate of rₖ - sₖ an estimate of xₖ, and for generating from said estimates of xₖ and rₖ - sₖ an estimate of sₖ, and for determining from said estimate of rₖ - sₖ and said estimate of sₖ an estimate of rₖ.

11. A receiver (50) according to claim 10, wherein, in the transmitter (10), sₖ is a multiple of a given value N which is chosen to cause xₖ and rₖ to occupy identical defined regions in space, where the total length and/or width of each defined region is the given value N, wherein:
said estimate of rₖ is determined according to 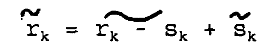
where 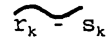 is said estimate of rₖ - sₖ, and 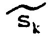 is an estimate of sₖ.

12. A receiver (50) according to claim 11, wherein:
said estimate 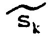 is selected so that 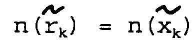 when said estimate 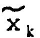 is other than an integer, and so that said estimate 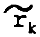 lies in the union of segments defined by 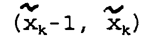 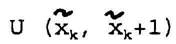 when said estimate 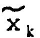 is an integer, wherein n is a region index function.

13. A receiver (50) according to claim 10, wherein:
rₖ, xₖ, and sₖ are complex numbers each having real and imaginary portion, and xₖ and rₖ are located within two-dimensional regions which are Cartesian products of two one-dimensional regions of total length N,
said estimate of rₖ - sk, said estimate of xₖ, and said estimate of rₖ are complex numbers each having real and imaginary portions.

14. A receiver (50) according to claim 13, wherein:
said estimate of rₖ is determined according to 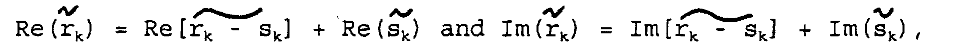 where 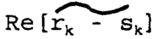 is said real portion of said estimate of rₖ - sₖ, Re( 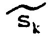 ) is the real portion of an estimate of sₖ, and 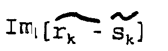 is said imaginary portion of said estimate of rₖ - sₖ, and Im( 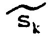 ) is the imaginary portion of an estimate of sₖ.

15. A receiver (50) according to claim 14, wherein:
said estimate 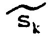 is selected so that 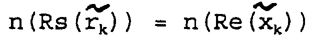 when Re( 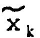 ) is other than an integer, and 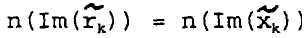 when Im( 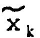 ) is other than an integer, and so that Re( 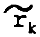 ) lies in the union of segments defined by 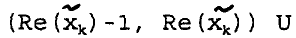 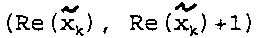 when Re( 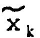 ) is an integer, and so that Im( 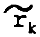 ) lies in the union of segments defined by 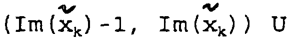 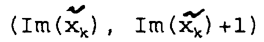 when Im( 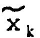 ) is an integer, wherein n is a region index function.

16. A receiver (50) according to claim 10, wherein:
said estimate of sₖ is generated by causing said estimate of sₖ to be an sₖ value which is closest to 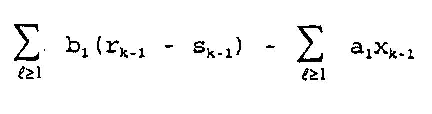
where 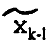 are estimates of previous xₖ.

17. A receiver (50) according to claim 16, wherein:
a₁xₖ₋₁ are previous xₖ estimates ( 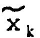 ), where xₖ is determined by multiplying said estimate of rₖ - sₖ by an approximation of said ISI according to 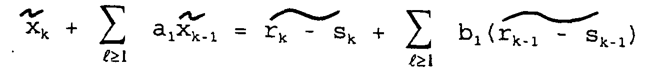
where 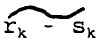 is said estimate of rₖ - sₖ.

18. A receiver (50) according to any of claims 11-17, wherein:
either said coefficients a₁ or b₁ are chosen as zero.

19. A receiver (50) according to claim 10, wherein:
said estimate of sₖ is generated by causing said estimate of rₖ - sₖ plus said estimate of sₖ to occupy an identical one of a plurality of defined regions in space as 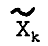 , where 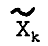 is an estimate of Xₖ, and Xₖ is an approximator of xₖ.

20. A receiver (50) according to claim 19, wherein:
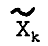 is determined by multiplying said estimate of rₖ - sₖ by an approximation of said ISI according to 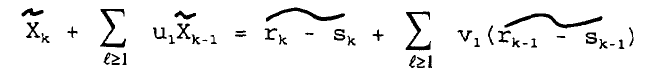
where u₁ and v₁ are respectively coefficients of first and second polynomials chosen to cause Xₖ to approximate xₖ.

21. A receiver (50) according to claim 10, wherein:
said estimate of sₖ is generated by causing said estimate of sₖ to be an sₖ value which is closest to 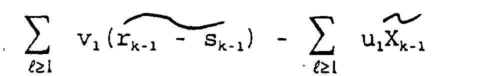
where Xₖ₋₁ are previous estimates of Xₖ ( 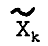 ) , Xₖ is an approximator of xₖ, and u₁ and v₁ are respectively coefficients of first and second polynomials chosen to cause Xₖ to approximate xₖ.

22. A receiver (50) according to claim 21, wherein:
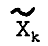 is determined by multiplying said estimate of rₖ - sₖ by an approximation of said ISI according to 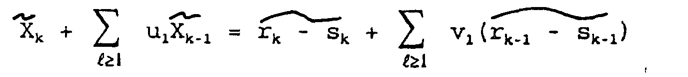
where 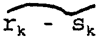 is said estimate of rₖ - sₖ.

23. A receiver (50) according to any of claims 20-22, wherein:
either said coefficients u₁ or v₁ are chosen as zero.

24. A telecommunications system, comprising:
a) a telecommunications channel (40);
b) a transmitter (10) for transmitting a series of data signals over said channel (40), said transmitter (10) including coding means (25) for precoding data signals according to a linear function; and
c) a receiver means (50) adapted for receiving a series of signals corresponding to said precoded output data signals; **characterised in that** said transmitter includes coding means for predistorting data signals according to a linear function 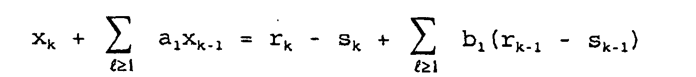 to provide predistorted output data signals, wherein rₖ represents a data signal which is to be predistorted by said coding means, a₁ and b₁ represent coefficients of polynomials relating to the channel impulse response of said channel (40), xₖ represents a predistorted output data signal, and sₖ is chosen to cause the signal power of xₖ on average to approximately equal the signal power of rₖ on average; and **in that** said receiver means is adapted for receiving a series of signals corresponding to said predistorted output data signals, said series of signals being said predistorted output data signals which were subjected to ISI of said channel (40) and noise, said receiver means (50) including means (55) for generating from a k'th signal of said series of signals an estimate of rₖ - sₖ, and decoder means (60) for generating from said estimate of rₖ - sₖ an estimate of xₖ, and from estimates of rₖ - sₖ and Xₖ an estimate of sₖ, and for determining from said estimate of sₖ and said estimate of rₖ - sₖ an estimate of rₖ.

25. A telecommunications system, comprising:
a) a telecommunications channel (40);
b) a transmitter (10) as set forth in any of claims 1-9; and
c) a receiver (50) as set forth in any of claims 10-23, where the receiver (50) is compatible with the transmitter (10).

## Patentansprüche

1. Sender (10) zum Senden einer Reihe von Datensignalen über einen Kanal (40), welcher Sender (10) aufweist:
Kodiermittel (25) zum Vorkodieren von Datensignalen entsprechend einer linearen Funktion, **dadurch gekennzeichnet, daß** die Kodiermittel dazu ausgebildet sind, Datensignale entsprechend der linearen Funktion 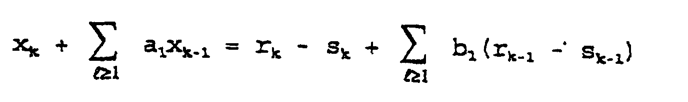 vorzuverzerren, um so vorverzerrte Ausgangssignale zu schaffen, wobei rₖ ein Datensignal darstellt, das durch die Kodiermittel vorverzerrt werden soll und a₁ und b₁ Koeffizienten von ersten bzw. zweiten Polynomen darstellen, die sich auf das Kanalimpulsansprechverhalten des Kanals beziehen, xₖ ein vorverzerrtes Ausgangsdatensignal darstellt, und sₖ so gewählt ist, daß bewirkt wird, daß die Signalleistung von xₖ im Durchschnitt ungefähr gleich der durchschnittlichen Signalleistung von rₖ ist.

2. Sender (10) nach Anspruch 1, bei dem sₖ so ausgewählt ist, daß bewirkt wird, daß xₖ ungefähr gleich rₖ ist.

3. Sender (10) nach Anspruch 1, bei dem sₖ entsprechend einer zweiten linearen Funktion 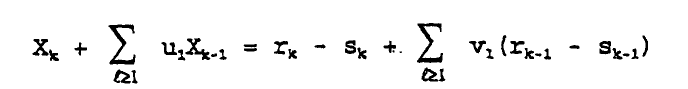 gewählt wird, wobei Xₖ ein Approximator von xₖ und u₁ und v₁ Koeffizienten von ersten bzw. zweiten Polynomen darstellen, die so ausgewählt sind, daß Xₖ xₖ approximiert und
sₖ ein Vielfaches eines gegebenen Wertes N ist, der durch die Kodiermittel so ausgewählt wird, daß bewirkt wird, daß Xₖ und rₖ identische definierte Bereiche im Raum einnehmen, wobei die Gesamtlänge und/oder Breite jedes definierten Bereich der gegebene Wert N ist.

4. Sender (10) nach Anspruch 1, bei dem
sₖ entsprechend einer zweiten linearen Funktion 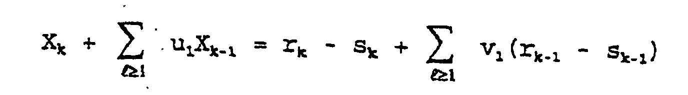 gewählt ist, wobei Xₖ ein Approximator von xₖ ist und u₁ und v₁ Koeffizienten von ersten bzw. zweiten Polynomen darstellen, die so gewählt sind, daß bewirkt wird, daß Xₖ xₖ approximiert, und
sₖ so gewählt ist, daß bewirkt wird, daß Xₖ ungefähr gleich rₖ ist.

5. Sender (10) nach Anspruch 3, bei dem
rₖ, Xₖ und sₖ komplexe Zahlen sind, die Real- und Imaginärteile haben und Xₖ und rₖ innerhalb identischer zweidimensionaler Bereich angeordnet sind, die kartesische Produkte eines definierten realen und definierten imaginären eindimensionalen Bereiches sind, die jeweils eine Gesamtlänge N haben.

6. Sender (10) nach Anspruch 1, bei dem
der Realteil von sₖ und der Imaginärteil von sₖ gerade ganze Zahlen sind und der Realteil von rₖ und der Imaginärteil von rₖ skalierte Datensignale sind.

7. Sender (10) nach Anspruch 1, bei dem
sₖ ein Vielfaches eines gegebenen Wertes N ist, der so gewählt ist, daß bewirkt wird, daß xₖ und rₖ identische definierte Bereiche im Raum einnehmen, wobei die Gesamtlänge und/oder Breite jedes definierten Bereiches der gegebene Wert N ist.

8. Sender (10) nach Anspruch 7, bei dem
rₖ, xₖ und sₖ reale Zahlen sind und die Bereiche der Länge N im Raum, die durch xₖ und rₖ eingenommen sind, entlang einer Linie verlaufen, oder
rₖ, xₖ und sₖ komplexe Zahlen sind, die Real- und Imaginärteile haben, und wobei xₖ und rₖ innerhalb identischer zweidimensionaler Bereiche angeordnet sind, die kartesische Produkte eines definierten realen und eines definierten imaginären eindimensionalen Bereiches sind, jeweils von einer Gesamtlänge N.

9. Sender (10) nach Anspruch 8, bei dem
wenn die Bereiche der Länge N im Raum, die durch xₖ und rₖ eingenommen sind, entlang einer Linie liegen, die definierten Bereiche jeweils eine Vereinigung von Segmenten aufweisen, wobei Punkte, die entgegengesetzte Werte haben, im selben Bereich Gₙ, sind, n ein Bereichsindex ist und rₖ eine nichtganzzahlige Realzahl ist, und
wenn xₖ und rₖ innerhalb identischer zweidimensionaler Bereiche angeordnet sind, jeder definierte reale eindimensionale Bereich eine Vereinigung von Segmenten aufweist, wobei Punkte, die entgegengesetzte Werte haben, im selben Bereich Gₙᵣ sind, wobei jeder definierte imaginäre eindimensionale Bereich eine Vereinigung von Segmenten aufweist, wobei Punkte, die entgegengesetzte Werte haben, im selben Bereich Gₙᵢ sind, wobei nᵣ und nᵢ Bereichsindizes sind und weder Re(rₖ) noch Im(rₖ) eine ganze Zahl ist.

10. Empfänger (50) zum Empfangen einer Reihe von Signalen über einen Kanal (40) von einem Sender (10), welcher Empfänger (50) Mittel (55) zum Empfangen der Reihe von Signalen und Dekodiermittel (60) aufweist, **dadurch gekennzeichnet, daß** die Reihe von Signalen zuerst entsprechend einer linearen Funktion 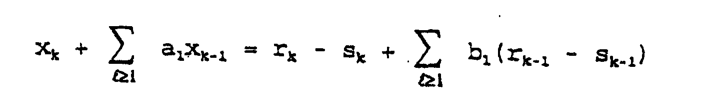 vorverzerrt worden ist und dann ISI (Inter Symbol Interference; Symbolinterferenz in Übertragungssystemen) des Kanals (40) und Rauschen ausgesetzt worden ist, wobei rₖ ein Signal darstellt, daß entsprechend der linearen Funktion vorverzerrt werden soll und a₁ und b₁ Koeffizienten von Polynomen darstellen, die sich auf die Kanal-ISI beziehen, xₖ ein Signal darstellt, das der ISI ausgesetzt worden ist und sₖ so ausgewählt ist, daß bewirkt wird, daß die Signalleistung von xₖ im Durchschnitt ungefähr der durchschnittlichen Signalleistung von rₖ ist, und daß
a) die Mittel (55) zum Empfangen der Reihe von Signalen dazu ausgebildet sind, vom k-ten Signal der Reihe von Signalen eine Schätzung von rₖ - sₖ zu erzeugen; und
b) die Dekodiermittel (60) zum Erzeugen aus der Schätzung von rₖ - sₖ eine Schätzung von xₖ und zum Erzeugen von den Schätzungen von xₖ und rₖ - sₖ eine Schätzung von sₖ, und zum Bestimmen von der Schätzung von rₖ - sₖ und dem Schätzwert von sₖ einen Schätzwert von rₖ vorgesehen sind.

11. Empfänger (50) nach Anspruch 10, bei dem im Sender (10) sₖ ein Vielfaches eines gegebenen Wertes N ist, der so ausgewählt ist, daß bewirkt wird, daß xₖ und rₖ identische definierte Bereiche im Raum einnehmen, wobei die gesamte Länge und/oder Breite jedes definierten Bereiches der gegebene Wert N ist, wobei
die Schätzung von rₖ entsprechend 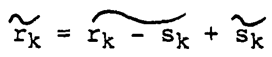 bestimmt ist, wobei 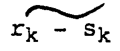 ein Schätzwert von rₖ - sₖ und 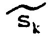 ein Schätzwert von sₖ ist.

12. Empfänger (50) nach Anspruch 11, bei dem
der Schätzwert 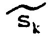 so ausgewählt ist, daß n( 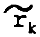 ) = n( 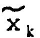 ) ist, wenn der Schätzwert 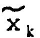 keine ganze Zahl ist, und so, daß der Schätzwert 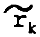 in der Vereinigung von Segmenten liegt, die durch 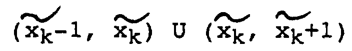 definiert ist, wenn der Schätzwert 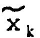 eine ganze Zahl ist, wobei n eine Bereichsindexfunktion ist.

13. Empfänger (50) nach Anspruch 10, bei dem
rₖ, xₖ und sₖ komplexe Zahlen sind, die jeweils einen Real- und einen Imaginärteil haben, und xₖ und rₖ innerhalb zweidimensionaler Bereiche angeordnet sind, die kartesische Produkte von zwei eindimensionalen Bereichen von einer Gesamtlänge N sind,
wobei der Schätzwert von rₖ - sₖ, der Schätzwert von xₖ und der Schätzwert rₖ komplexe Zahlen sind, die jeweils Real- und Imaginärteile haben.

14. Empfänger (50) nach Anspruch 13, bei dem
der Schätzwert von rₖ entsprechend 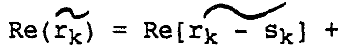 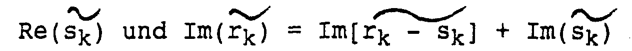 bestimmt wird, wobei 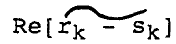 der Realteil des Schätzwertes von rₖ - sₖ ist, Re( 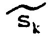 ) der Realteil des Schätzwertes von sₖ ist, und 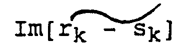 der Imaginärteil des Schätzwertes von rₖ - sₖ ist, und Im( 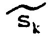 ) der Imaginärteil eines Schätzwertes von sₖ ist.

15. Empfänger (50) nach Anspruch 14, bei dem
der Schätzwert 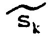 so ausgewählt wird, daß 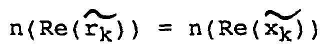 ist, wenn Re( 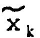 ) keine ganze Zahl ist, und 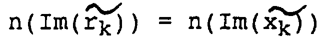 ist, wenn Im( 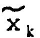 ) keine ganze Zahl ist, und so, daß Re( 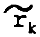 ) in der Vereinigung von Segmenten liegt, die definiert werden durch 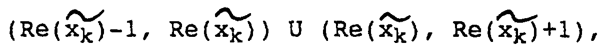 wenn Re( 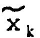 ) eine ganze Zahl ist, und so, daß Im( 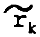 ) in der Vereinigung der Segmente liegt, die definiert werden durch 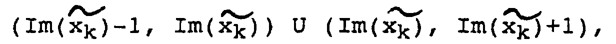 wenn Im( 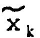 ) eine ganze Zahl ist, wobei n eine Bereichsindexfunktion ist.

16. Empfänger (50) nach Anspruch 10, bei dem
der Schätzwert von sₖ dadurch erzeugt wird, daß bewirkt wird, daß der Schätzwert von sₖ ein sₖ-Wert ist, der am nächsten ist an 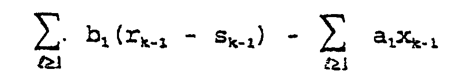 wo 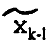 Schätzwerte von vorhergehenden xₖ sind.

17. Empfänger (50) nach Anspruch 16, bei dem
a₁xₖ₋₁ vorhergehende xₖ-Schätzwerte ( 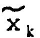 ) sind, wo xₖ dadurch bestimmt ist, daß der Schätzwert von rₖ - sₖ mit einer Approximation der ISI gemäß 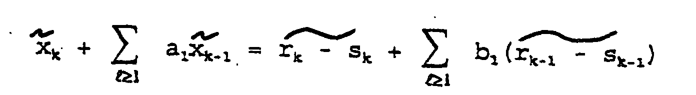 multipliziert wird, wobei 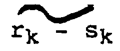 der Schätzwert von rₖ - sk ist.

18. Empfänger (50) nach einem der Ansprüche 11 bis 17, bei dem
mindestens einer der Koeffizienten a₁ oder b₁ als Null gewählt ist.

19. Empfänger (50) nach Anspruch 10, bei dem
der Schätzwert von sₖ dadurch erzeugt wird, daß bewirkt wird, daß der Schätzwert von rₖ - sₖ plus der Schätzwert von sₖ denselben der Mehrzahl von definierten Bereichen im Raum einnehmen wie 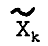 , wobei 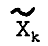 ein Schätzwert von Xₖ und Xₖ ein Approximator von xₖ ist.

20. Empfänger (50) nach Anspruch 19, bei dem
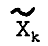 dadurch bestimmt wird, daß der Schätzwert von rₖ - sₖ mit einer Approximation der ISI gemäß 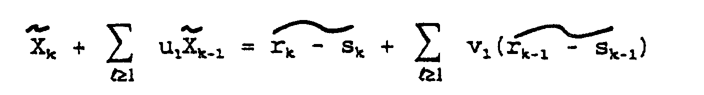 multipliziert wird, wobei u₁ und v₁ Koeffizienten von ersten bzw. zweiten Polynomen sind, die ausgewählt sind, damit Xₖ xₖ approximiert.

21. Empfänger (50) nach Anspruch 10, bei dem
der Schätzwert von sₖ dadurch erzeugt wird, daß bewirkt wird, daß der Schätzwert von sₖ ein sₖ-Wert ist, der am nächsten zu 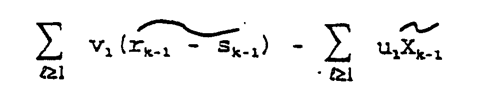 ist, wobei Xₖ₋₁ vorherige Schätzwerte von Xₖ ( 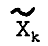 ) sind, Xₖ ein Approximator von xₖ ist und u₁ und v₁ Koeffizienten von ersten bzw. zweiten Polynomen sind, die dazu ausgewählt sind, daß bewirkt wird, daß Xₖ xₖ approximiert.

22. Empfänger (50) nach Anspruch 21, bei dem
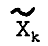 dadurch bestimmt wird, daß der Schätzwert von rₖ - sₖ mit einer Approximation der ISI gemäß 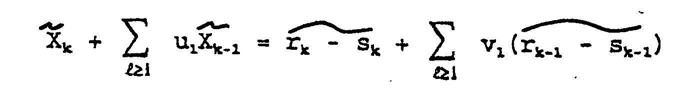 bestimmt wird, wobei 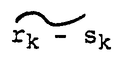 der Schätzwert von rₖ - sₖ ist.

23. Empfänger (50) nach einem der Ansprüche 20 bis 22, bei dem
mindestens einer der Koeffizienten u₁ oder v₁ als Null gewählt ist.

24. Telekommunikationssystem, das aufweist:
a) einen Telekommunikationskanal (40);
b) einen Sender (10) zum Senden einer Reihe von Datensignalen über den Kanal (40), welcher Sender (10) Kodiermittel (25) zum Vorkodieren von Datensignalen gemäß einer linearen Funktion einschließt; und
c) Empfängermittel (50), die dazu ausgebildet sind, eine Reihe von Signalen zu empfangen, die den vorkodierten Ausgangsdatensignalen entsprechen; **dadurch gekennzeichnet, daß** der Sender Kodiermittel zum Vorverzerren von Datensignalen gemäß einer linearen Funktion 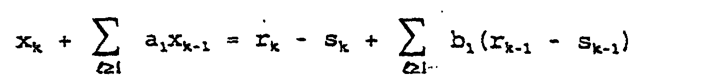 einschließt, um vorverzerrte Ausgangsdatensignale zur Verfügung zu stellen, wobei rₖ ein Datensignal darstellt, das durch die Kodiermittel vorverzerrt werden soll, a₁ und b₁ Koeffizienten von Polynomen darstellen, die sich auf das Kanalimpulsansprechverhalten des Kanals (40) beziehen, xₖ ein vorverzerrtes Ausgangsdatensignal darstellt, und sₖ so ausgewählt ist, daß bewirkt wird, daß die durchschnittliche Signalleistung von xₖ ungefähr gleich der durchschnittlichen Signalleistung von rₖ ist; und daß die Empfängermittel dazu ausgebildet sind, eine Reihe von Signalen zu empfangen, die den vorverzerrten Ausgangsdatensignalen entsprechen, welche Reihe von Signalen die vorverzerrten Ausgangsdatensignale sind, die ISI dieses Kanals (40) und Rauschen ausgesetzt worden sind, wobei die Empfängermittel (50) Mittel (55) zum Erzeugen eines Schätzwerts von rₖ - sₖ von einem k-ten der Reihe von Signalen einschließen, und Dekodiermittel (60) einschließen, um von dem Schätzwert von rₖ - sₖ einen Schätzwert von xₖ zu erzeugen, und um von den Schätzwerten von rₖ - sₖ und Xₖ einen Schätzwert von sₖ zu erzeugen, und um aus dem Schätzwert von sₖ und dem Schätzwert von rₖ - sₖ einen Schätzwert von rₖ zu bestimmen.

25. Telekommunikationssystem, das aufweist:
a) einen Telekommunikationskanal (40);
b) einen Sender (10) nach einem der Ansprüche 1 bis 9; und
c) einen Empfänger (50) nach einem der Ansprüche 10 bis 23, wobei der Empfänger (50) mit dem Sender (10) kompatibel ist.

## Revendications

1. Un transmetteur (10) pour transmettre une série de signaux de données par un canal (40), ledit transmetteur (10) comprenant :
des moyens de codage (25) pour précoder des signaux de données selon une fonction linéaire, **caractérisé en ce que** les moyens de codage sont adaptés pour prédécomposer des signaux de données selon la fonction linéaire : 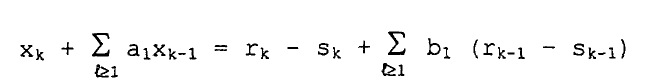
de manière à fournir des signaux de données de sortie prédécomposés, dans laquelle rₖ représente un signal de données qui doit être prédécomposé par lesdits moyens de codage, a1 et b1 représentent respectivement des coefficients d'un premier et d'un second polynômes relatifs à la réponse en impulsion de canal dudit canal , xₖ représente un signal de données de sortie prédécomposé et sₖ est choisi pour rendre la puissance de signal de xₖ en moyenne approximativement égale à la puissance de signal de rₖ en moyenne.

2. Un transmetteur (10) selon la revendication 1, dans lequel :
sₖ est choisi pour faire que xₖ soit approximativement égal à rₖ.

3. Un transmetteur (10) selon la revendication 1,
dans lequel sₖ est choisi selon une seconde fonction linéaire 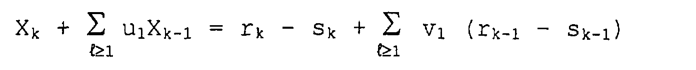 dans laquelle Xₖ une valeur approximative de xₖ, et u₁ et v₁ représentent respectivement des coefficients d'un premier et d'un second polynômes choisis pour faire que Xₖ soit une approximation de xₖ, et
sₖ est un multiple d'une valeur donnée N qui est choisie par lesdits moyens de codage pour faire que Xₖ et rₖ occupent des zones définies identiques dans l'espace, où la longueur et/ou la largeur totale de chaque zone définie est la valeur donnée N.

4. Un transmetteur (10) selon la revendication 1, dans lequel :
sₖ est choisi selon une seconde fonction linéaire 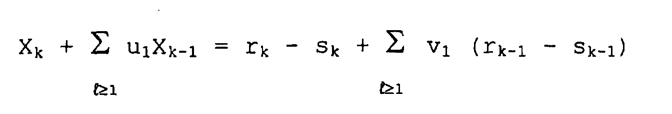
dans laquelle Xₖ est une valeur approximative de xₖ, et u₁ et v₁ représentent respectivement des coefficients de premier et second polynômes choisis pour faire que Xₖ soit une approximation de xₖ, et sₖ est choisi pour faire que Xₖ soit approximativement égal à rₖ.

5. Un transmetteur (10) selon la revendication 3, dans lequel :
rₖ, Xₖ et sₖ sont des nombres complexes ayant des parties réelle et imaginaire, et Xₖ et rₖ sont situés dans des zones à deux dimensions identiques qui sont des produits cartésiens d'une zone définie réelle à une dimension et d'une zone définie imaginaire à une dimension, chacune d'une longueur totale N.

6. Un transmetteur (10) selon la revendication 1, dans lequel :
la partie réelle de sₖ et la partie imaginaire de sₖ sont toujours des entiers et la partie réelle de rₖ et la partie imaginaire de rₖ sont des signaux de données gradués.

7. Un transmetteur (10) selon la revendication 1, dans lequel :
sₖ est un multiple d'une valeur donnée N qui est choisie pour forcer xₖ et rₖ à occuper des zones définies identiques dans l'espace, où la longueur et/ou la largeur totale de chaque zone définie est la valeur donnée N.

8. Un transmetteur (10) selon la revendication 7, dans lequel :
rₖ, xₖ et sₖ sont des nombres réels et les zones de longueur N dans l'espace occupées par xₖ et rₖ sont le long d'une ligne, ou
rₖ, xₖ et sₖ sont des nombres complexes ayant des parties réelle et imaginaire, et xₖ et rₖ sont situés dans des zones à deux dimensions identiques qui sont des produits cartésiens d'une zone définie réelle à une dimension et d'une zone définie imaginaire à une dimension, chacune de longueur totale N.

9. Un transmetteur (10) selon la revendication 8, dans lequel :
si les zones de longueur N dans l'espace occupées par xₖ et rₖ sont le long d'une ligne, lesdites zones définies comprennent chacune une union de segments, dans lesquels les points ayant des valeurs opposées sont dans la même zone Gₙ, n étant un index de zone, et rₖ est un nombre réel non entier et
si xₖ et rₖ sont situés dans des zones à deux dimensions identiques, chaque dite zone définie réelle à une dimension comprend une union de segments, dans lesquels les points ayant des valeurs opposées sont dans la même zone Gₙᵣ, chaque dite zone définie imaginaire à une dimension comprend une union de segments, dans lesquels les points ayant une valeur opposée sont dans la même zone Gₙᵢ, dans lequel nᵣ et nᵢ sont des indices de zone, et ni Re(rₖ) ni Im(rₖ) n'est un entier.

10. Un récepteur (50) pour recevoir une série de signaux par un canal (40) depuis un transmetteur (10), ledit récepteur (50) comprenant des moyens (55) pour recevoir ladite série de signaux, et des moyens de décodage (60) ; **caractérisé en ce que** ladite série de signaux a été d'abord prédécomposée selon une fonction linéaire 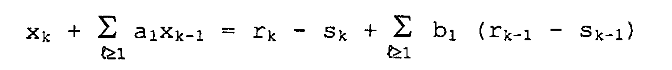 et ensuite soumise à l'ISI dudit canal (40) et au bruit, dans laquelle rk représente un signal qui doit être prédécomposé selon ladite fonction linéaire, a₁ et b₁ représentent des coefficients de polynômes relatifs à ladite ISI du canal, xₖ représente un signal qui est soumis à ladite ISI et sₖ est choisi pour rendre la puissance du signal de xₖ en moyenne approximativement égale à la puissance du signal de rₖ en moyenne, et **en ce que**
a) lesdits moyens (55) pour recevoir ladite série de signaux sont adaptés pour générer à partir d'un kième signal de ladite série de signaux une estimation de (rₖ-sₖ) ; et
b) lesdits moyens de décodage (60) sont adaptés pour générer à partir de ladite estimation de (rₖ-sₖ) une estimation de xₖ, et pour générer à partir desdites estimations de xₖ et (rₖ-sₖ) une estimation de sₖ, et pour déterminer à partir de ladite estimation de (rₖ-sₖ)et de ladite estimation de sₖ une estimation de rₖ.

11. Un récepteur (50) selon la revendication 10, dans lequel, dans le transmetteur (10), sk est un multiple d'une valeur donnée N qui est choisie pour forcer xₖ et rₖ à occuper des zones définies identiques dans l'espace, où la longueur et/ou la largeur totale de chaque zone définie est la valeur donnée N, dans lequel :
ladite estimation de rₖ est déterminée selon 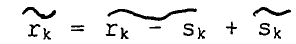 dans laquelle 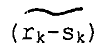 est ladite estimation de (rₖ - sₖ), et 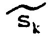 est une estimation de sₖ.

12. Un récepteur (50) selon la revendication 11, dans lequel :
ladite estimation 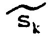 est choisie de telle sorte que 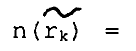 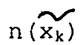 n( 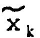 ) lorsque ladite estimation 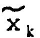 est autre qu'un entier et de telle sorte que ladite estimation 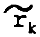 se tient dans l'union des segments définie par 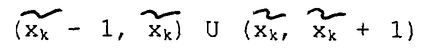 lorsque ladite estimation 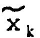 est un entier, dans lequel n est une fonction de l'index de zone.

13. Un récepteur (50) selon la revendication 10, dans lequel :
rₖ, xₖ et sₖ sont des nombres complexes ayant chacun une partie réelle et une partie imaginaire, et xₖ et rₖ sont situés dans des zones à deux dimensions qui sont des produits cartésiens de deux zones à une dimension de longueur totale N,
ladite estimation de (rₖ-sₖ), ladite estimation de xₖ et ladite estimation de rₖ sont des nombres complexes ayant chacun des parties réelle et imaginaire.

14. Un récepteur (50) selon la revendication 13, dans lequel :
ladite estimation de rₖ est déterminée selon 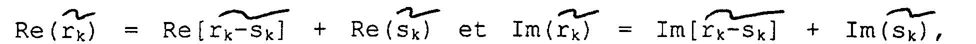
dans laquelle 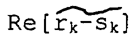 est ladite partie réelle de ladite estimation de (rₖ-sₖ), Re ( 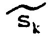 ) est la partie réelle d'une estimation de sₖ, et 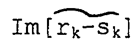 est ladite partie imaginaire de ladite estimation de (rₖ-sₖ) et Im( 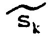 ) est la partie imaginaire d'une estimation de sₖ.

15. Un récepteur (50) selon la revendication 14, dans lequel ladite estimation 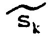 est choisie de telle manière que 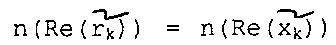 lorsque Re( 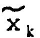 ) est autre qu'un entier, et 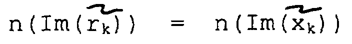 lorsque Im( 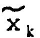 ) est autre qu'un entier, et de telle sorte que Re( 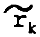 ) se tient dans l'union de segments définie par 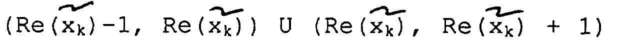 lorsque Re( 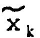 ) est un entier, et de telle sorte que Im( 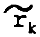 ) se tient dans l'union de segments définie par 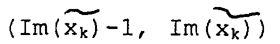 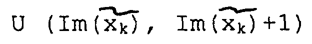 lorsque Im( 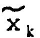 ) est un entier, dans lequel n est une fonction de l'index de zone.

16. Un récepteur (50) selon la revendication 10, dans lequel :
ladite estimation de sₖ est générée en faisant que ladite estimation de sₖ soit une valeur sₖ qui est la plus proche de 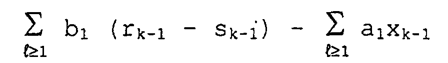
où 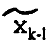 sont des estimations des xₖ antérieurs.

17. Un récepteur (50) selon la revendication 16, dans lequel :
a₁xₖ-1 sont des estimations ( 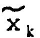 ) des xₖ antérieurs, où xₖ est déterminé en multipliant ladite estimation de (rₖ-sₖ) par une valeur approximative de ladite ISI selon 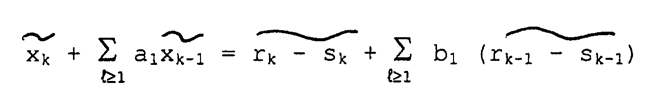
où 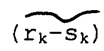 est ladite estimation de (rₖ-sₖ).

18. Un récepteur (50) selon l'une quelconque des revendications 11-17, dans lequel
l'un et l'autre desdits coefficients a₁ ou b₁ sont à la valeur zéro.

19. Un récepteur (50) selon la revendication 10, dans lequel :
ladite estimation de sₖ est générée en faisant que ladite estimation de (rₖ - sₖ) plus ladite estimation de sₖ occupe une zone identique d'une pluralité de zones définies dans l'espace sous forme de 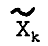 , où 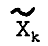 est une estimation de Xₖ et Xₖ est une valeur approximative de xₖ.

20. Un récepteur (50) selon la revendication 19, dans lequel :
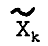 est déterminé en multipliant ladite estimation de (rₖ - sₖ) par une valeur approximative de ladite ISI selon 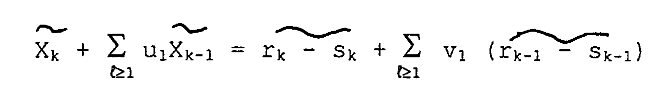
dans laquelle u₁ et v₁ sont respectivement des coefficients de premier et second polynômes choisis pour faire que Xₖ soit une approximation de xₖ.

21. Un récepteur (50) selon la revendication 10, dans lequel :
ladite estimation de sₖ est générée en faisant que ladite estimation de sₖ soit une valeur sₖ qui est la plus proche de 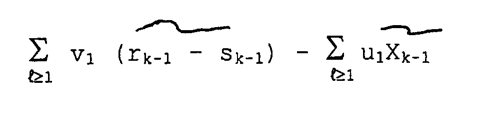
dans laquelle Xₖ₋₁ sont des estimations ( 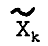 ) des Xₖ antérieurs, Xₖ est une valeur approximative de xₖ, et u₁ et v₁ sont respectivement les coefficients de premier et second polynômes choisis pour faire que Xₖ soit une approximation de xₖ.

22. Un récepteur (50) selon la revendication 21, dans lequel :
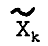 est déterminé en multipliant ladite estimation de (rₖ - sₖ) par une valeur approximative de ladite ISI selon 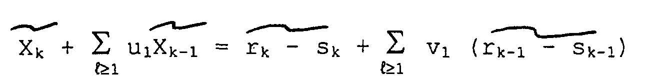
dans laquelle 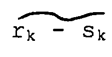 est ladite estimation de (rₖ- sₖ)

23. Un récepteur (50) selon l'une quelconque des revendications 20-22, dans lequel
l'un ou l'autre desdits coefficients u₁ et v₁ est choisi à la valeur zéro.

24. Un système de télécommunication comprenant :
a) un canal de télécommunication (40) ;
b) un transmetteur (10) pour transmettre une série de signaux de données par ledit canal (40), ledit transmetteur (10) incluant des moyens de codage (25) pour précoder des signaux de données selon une fonction linéaire ; et
c) des moyens de réception (50) adaptés pour recevoir une série de signaux correspondant auxdits signaux de données de sortie précodés, **caractérisé en ce que** ledit transmetteur inclut des moyens de codage pour prédécomposer les signaux de données selon une fonction linéaire 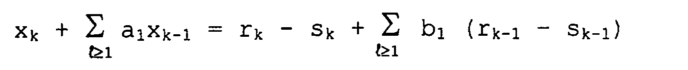 pour fournir des signaux de données de sortie prédécomposés,
dans laquelle rₖ représente un signal de données qui doit être prédécomposé par lesdits moyens de codage, a₁ et b₁ représentent des coefficients de polynômes relatifs à la réponse en impulsion de canal dudit canal (40), xₖ représente un signal de données de sortie prédécomposé et sₖ est choisi pour rendre la puissance du signal de xₖ en moyenne approximativement égale à la puissance du signal de rₖ en moyenne ; et **en ce que** lesdits moyens de réception sont adaptés pour recevoir une série de signaux correspondant auxdits signaux de données de sortie prédécomposés, ladite série de signaux étant lesdits signaux de données de sortie prédécomposés qui ont été soumis à l'ISI dudit canal (40) et au bruit, lesdits moyens de réception (50) incluant des moyens (55) pour générer à partir d'un kième signal de ladite série de signaux une estimation de (rₖ - sₖ) et des moyens de décodage (60) pour générer à partir de ladite estimation de (rₖ - sₖ) une estimation de xₖ, et à partir desdites estimations de (rₖ - sₖ) et xₖ, une estimation de sₖ, et pour déterminer de ladite estimation de sₖ et de ladite estimation de (rₖ - sₖ) une estimation de rₖ.

25. Un système de télécommunications, comprenant :
a) un canal de télécommunication (40) ;
b) un transmetteur (10) tel que défini dans l'une quelconque des revendications 1-9 et
c) un récepteur (50) tel que défini dans l'une quelconque des revendications 10-23, dans lequel le récepteur (50) est compatible avec le transmetteur (10).
